# EUROPEAN PATENT SPECIFICATION

(11) **EP 0 590 904 B1**
(45) Date of publication and mention of the grant of the patent: **19.05.1999**
(21) Application number: 93307621.8
(22) Date of filing: 27.09.1993
(51) Int. Cl.: C23C 14/34

(54) **Method of manufacturing a diffusion-bonded sputtering target assembly**
Verfahren zur Herstellung eines diffusionsgebundenen Zerstäubungs-Target-Bauteil
Méthode pour la fabrication d'un elément cible à pulverisation cathodique lié par diffusion

(30) Priority: 29.09.1992 JP 282297/92; 24.11.1992 JP 334899/92; 07.12.1992 JP 351106/92
(43) Date of publication of application: 06.04.1994
(60) Divisional application: 97118420.5
(73) Proprietor: JAPAN ENERGY CORPORATION, Minato-ku, Tokyo (JP)
(72) Inventor: Ohhashi, Tateo, c/o Nikko Kyodo Co., Ltd., Kitaibaraki-shi, Ibaraki-ken (JP); Fukuyo, Hideaki, c/o Nikko Kyodo Co., Ltd., Kitaibaraki-shi, Ibaraki-ken (JP); Sawamura, Ichiroh, c/o Nikko Kyodo Co., Ltd., Kitaibaraki-shi, Ibaraki-ken (JP); Nakamura, Kenichirou, c/o Nikko Kyodo Co., Ltd., Kitaibaraki-shi, Ibaraki-ken (JP); Fukushima, Atsushi, c/o Nikko Kyodo Co., Ltd., Kitaibaraki-shi, Ibaraki-ken (JP); Nagasawa, Masaru, c/o Nikko Kyodo Co., Ltd., Kitaibaraki-shi, Ibaraki-ken (JP)
(74) Representative: Drever, Ronald Fergus

(56) References cited:
- EP-A- 342 894
- EP-A- 0 466 617
- EP-A- 0 500 031
- PATENT ABSTRACTS OF JAPAN, unexamined applications, C section, vol. 16, no. 419, September 03, 1992 THE PATENT OFFICE JAPANESE GOVERNMENT page 38 C 981; & JP-A-04 143 268 (FUJITSU LTD)
- PATENT ABSTRACTS OF JAPAN, unexamined applications, C section, vol. 16, no. 419, September 03, 1992 THE PATENT OFFICE JAPANESE GOVERNMENT page 38 C 981; & JP-A-04 143 269 (FUJITSU LTD)
- Kirk-Othmer "Encyclopedia of Chemical Technology", Third Edition, Volume 13, J. Wiley & Sons, NY, US, pages 13-948 to 13-949, 1981

## Description

This invention relates to a sputtering target assembly composed of a sputtering target and a backing plate, and more specifically to a sputtering target assembly and a method of manufacturing the same featuring by bonding a sputtering target and a backing plate by solid-phase diffusion bonding, with or without an insert or inserts placed therebetween.

By solid-phase diffusion bonding, a sputtering target exhibits excellent adhesion and bond strength to a backing plate while maintaining its structure and crystal characteristics including crystal gain size, crystal orientation etc. which it had before the diffusion bonding with no contamination possibly caused by the bonding process.

Sputtering targets serve as sputtering sources to form electrodes, gates, wirings, elements, protective films and the like of various semiconductor devices on substrates by sputtering operation. They usually take the form of disk-shaped plates. As accelerated particles impinge against a target surface, part of the atoms constituting the target is sputtered to the space by momentum exchange to deposit on an oppositely located substrate. Typical sputtering targets in use include Al and Al alloy targets, a refractory metal and its alloy (W, Mo, Ti, Ta, Zr, Nb, etc. and their alloys such as W-Ti) targets, and high-melting silicide (MoSiₓ, WSix, etc.) targets. The targets are usually used in the form of assembly integrally bonded with a backing material, known as a backing plate, which provides both support and cooling functions. A sputtering target assembly is mounted in a sputtering system, and the rear side of the backing plate is cooled to dissipate the heat that is generated in the target during sputtering operation. The backing plates in use today are made of metals and alloys with good thermal conductivities, such as oxygen-free copper (OFC), Cu alloys, Al alloys, stainless steels (SUS), and Ti and Ti alloys.

Heretofore, for the bonding of a sputtering target and a backing plate to constitute a sputtering target assembly, brazing method using a low-melting brazing material such as In or Sn alloy has been primarily employed. But, the brazing technique using a low-melting brazing material has the following disadvantages:
(1) The low melting point of brazing materials, 158 °C for In or 160-300 °C even for an Sn alloy, causes a sharp drop of the bond strength under shear as the service temperatures approaches its melting point. Specifically, the bond strength under shear at room temperature is less than 1 kgf/mm² for In and 2-4 kgf/mm² for even an Sn alloy which has relatively high strength. This combines with the low melting point of the brazing material to cause a sharp drop of the bond strength under shear upon temperature rise.
(2) With the brazing technique, 100% bonding with no un-bonded portions is difficult to achieve since the contraction upon solidification of the brazing material during the bonding process leaves pores (air gaps) behind along the bonded interfaces between the target and backing plate.

Consequently, the electric power to be provided for sputtering is limited to a low level. Also, when the system is loaded with greater sputtering power than specified or operated under inadequate cooling water control, troubles such as the separation of the target are caused due to a decrease in bond strength upon temperature rise of the target or melting of the brazing material.

The employment of a high-melting brazing material in place of the low-melting one requires a higher temperature for brazing, which sometimes affects the target quality adversely.

A recent tendency is toward the use of greater electric power for sputtering to improve the throughput for film forming by sputtering. In view of this, there is strong demand for a target which is capable of maintaining the bond strength above a predetermined level even at elevated temperatures.

Meanwhile, Japanese Patent Application Public Disclosure Nos. 143268/1992 and 143269/1992 disclosed targets and methods of manufacturing them which involve a process of integrally bonding a first metal member that serves as a sputtering material to a second metal member that serves as a support either directly or through the interposition of a spacer having a higher melting point than the first metal member. As regards the method of integrally bonding them together, explosive welding is primarily explained. Others referred to as employable are hot press, HIP, and hot roll methods. Taking the hot press method for example, it is described as comprising the steps of working and machining, e.g., an al-1%Si alloy as the first metal member (sputtering material) and oxygen-free copper as the second metal member (support), both to relatively simple shapes, and bonding the two members by hot pressing at 300-500° C for 60 minutes, whereby a diffusion layer of about 2 µm thickness is said to be formed, and thereafter machining the first and second metal members (sputtering material and support) thus bonded together to final configurations. It is also stated to the effect that alternatively the first and second metal members having been machined to desired shapes may be bonded by explosive welding.

The methods described above involve high pressure bonding of the first and second metal members under very great impact or heavy load such as a explosive bonding, hot press, HIP, or hot roll technique. This process causes serious deformation of the first metal member to be sputtered (target material), and attendant increased internal strains and the change of crystal structure.

Particularly, the uniformity as of crystal size and crystal orientation of a target is destroyed resulting in different crystal grain diameters and crystal orientations on various locations of the target. As a result, the quantity of sputter from the target begins to vary from point to point which leads to variation of deposited film thickness and hence deposited film properties. This problem is recently pointed out that this is a matter of serious concern. Further, the contamination of surface layer of the target produced is severe and so the yield of target material to be finished to the final size is very poor. Although it is also stated in the above mentioned publication that the first and second metal members may be bonded by explosive bonding after they have been machined to desired configurations, in that case, deformation of the target material and attendant increased internal strains and the change of crystal structure, and surface layer contamination are inevitable as stated above.

Recently, target materials having melting points below 1000° C, e.g., aluminum or aluminum alloys, have rapidly come into use for the wirings or interconnections of semiconductor devices. These target materials in many cases are supplied as finished to final geometry with very high purity. Such relatively lower melting target materials are susceptible to larger damages of its crystal structure, sometimes accompanied with coarsening of grain size of the target material.

Earlier European application EP-A-0 630 423 discloses a method of manufacturing a sputtering target assembly, comprising a target and a backing plate with an insert interposed therebetween, the method comprising diffusion bonding using inter alia a temperature of 550-625°C.

The present invention has for its object the development of a technique for bonding a target material finished to the final geometry or near net shape of the final geometry to a backing plate with a high strength while maintaining the uniformity of the crystal structure and imparting no deformative, degrading, or other unfavourable effect upon the target material itself.

According to this invention there is provided a method of manufacturing a sputtering target assembly having a target and a backing plate bonded thereto, comprising laminating the target of a given final shape, said target having a melting point below 1000°C, and the backing plate of a given final shape with at least one insert interposed therebetween, and solid-phase diffusion bonding the target to the backing plate, wherein said solid-phase diffusion bonding takes place under a vacuum at a temperature between 150 and 300°C and at a pressure of between 9.8MPa (1kgf/mm²) and 196MPa (20kgf/mm²) whereby the structure and crystal characteristics possessed by the target before being diffusion bonded to the backing plate are maintained after diffusion bonding and said target having a uniform crystal structure with a grain size not exceeding 250 µm.

The present inventors have searched for a bonding method for target materials which inhibits the crystal characteristics such as crystal grain growth and causes little deformative or other adverse effects upon the material. As a result, it has now been found that solid-phase diffusion bonding with or without the use of an insert produces a far better bond than expected in their interfaces. The diffusion bonding, performed while maintaining a solid phase under a light load (a low strain rate) in a vacuum, gives high adhesion and high bond strength with no or very small deformation of the target material and with no un-bonded portions such as pores along the interfaces, while inhibiting the destruction of uniform crystal structure, the growth of grains, etc. which the target material had before the bonding.

The term "solid phase diffusion bonding" as used herein means a technique of bonding a target material and a backing plate with or without an insert or inserts sandwiched therebetween by diffusion along the interfaces under light heating and pressing conditions, whereby the two members are bonded while maintaining the solid phase rather than being melted, without causing unfavorable effects upon the target material including its grain growth and structure change.

Based upon this discovery, one aspect of this invention provides a sputtering target assembly comprising a sputtering target and a backing plate characterised in that said sputtering target and backing plate are solid-phase diffusion-bonded with or without an insert or inserts interposed therebetween so as to have solid phase diffusion-bonded interfaces therebetween, said diffusion-bonded sputtering target substantially maintaining metallurgical characteristics and properties that the sputtering target had before it is diffusion-bonded to said backing plate.

Typically the target material consists of aluminum or an aluminum alloy. The insert typically consists of silver or a silver alloy, copper or copper alloy, or nickel or a nickel alloy.

The solid-phase diffusion bonding of the target and backing plate, with one or more inserts sandwiched therebetween, at a low temperature and pressure causes interdiffusion of their constituent atoms to attain high adhesion and bond strength without attendant deterioration or deformation of the target material, while inhibiting the crystal grain growth in the target material. The bond thus obtained proves highly reliable because it undergoes no abrupt decrease in bond strength upon elevation of the service temperature and, owing to the solid phase bonding, 100% bonding is achieved with no un-bonded portions such as pores left along the interfaces.

FIG. 1 is a perspective view of a sputtering target assembly consisting of a target material and a backing plate bonded through an insert by solid-phase diffusion bonding in accordance with this invention.

FIG. 2 is a graph comparing the bond strength values under shear at room temperature of the diffusion-bonded target assembly of this invention with those of the bonded material that used a low-melting brazing material of the Sn-Pb-Ag system in Example 1.

FIG. 3 is a graph showing the temperature dependence of the bond strength values under shear of the bonded materials of Example 1.

FIG. 4 is a micrograph showing the metallographic structure in the vicinity of bonded interfaces of an assembly consisting of an Al-1%Si-0.5% Cu target, Ag foil, and an OFC backing plate according to this invention.

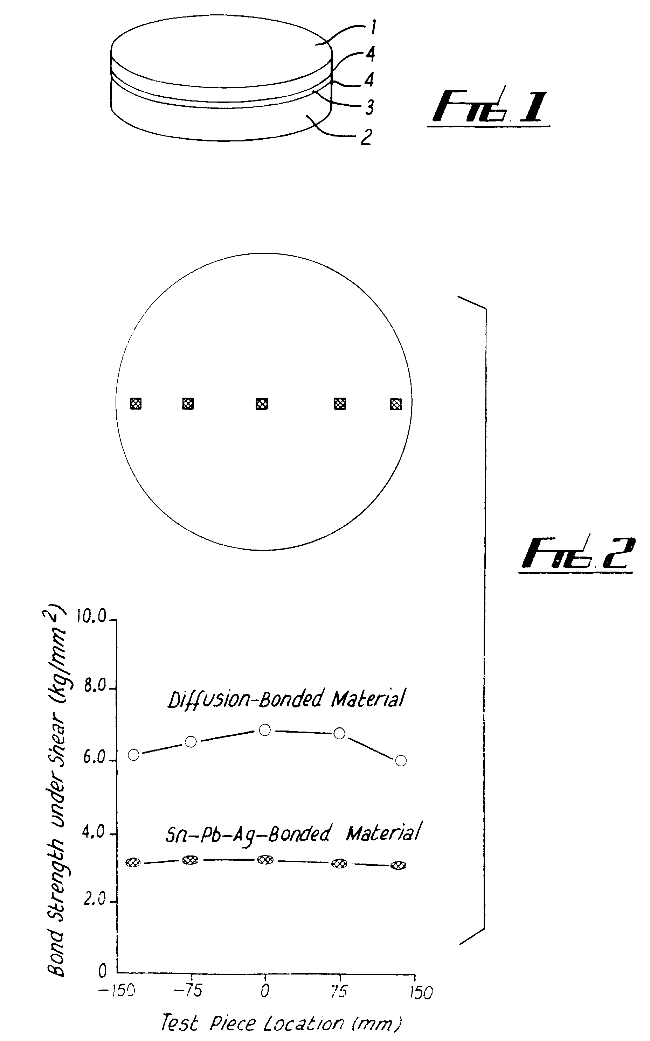

There is shown in FIG. 1 a diffusion-bonded sputtering target assembly manufactured by diffusion-bonding a target material 1 and a backing plate 2 through an insert 3 in accordance with this invention. The components are solidly bonded together with solid-phase diffusion-bonded interfaces 4. The insert 3 used depends upon a combination of the target material and the backing plate. The target material maintains the metallurgical characteristics and properties that it had before diffusion bonding.

Typical examples of target materials having a melting point no more than 1000 °C are aluminum and aluminum alloys such as Al-Si-Cu, Al-Si, and Al-Cu alloys. Other alloy targets composed principally of such metals as Cu or Au also come within the contemplation of this group. As for insert materials, Ag, Cu, Ni, or their alloys are usually used. One or more such insert materials are used in layers.

In fabricating a sputtering target assembly with the use of insert(s), a backing plate and a target material are degreased and rinsed with an organic solvent like acetone. Then, between the two is interposed an insert of one or more materials chosen from among Ag, Cu, Ni, and their alloys, desirably having at least 10 µm thickness. The insert too must be degreased and rinsed beforehand. The use of a 10 µm or thicker insert is desirable because the micropores that result from surface irregularities, on the order of several micrometers, caused by machining of the surfaces of the target and backing plate to be bonded, would otherwise lessen the adhesive strength. The upper limit of thickness of the insert is not specified provided the insert is thick enough for solid-phase diffusion bonding. Excessive thickness is wasteful, however. A conventional foil, thin sheet or the like may be employed. For the material of the insert, Ag, Cu, Ni, or their alloy is suitable as referred to above, by reason of moderately high melting point and diffusionability to permit solid phase diffusion bonding. The insert is not limited to a single layer. Two or more superposed layers may be used instead. The surfaces to be bonded should be free from oxides or other impurities.

In the case of a target materials having a melting temperature no more than 1000 °C, a laminate consisting of a target material, a backing plate, and an insert is generally diffusion-bonded in a solid state by holding it at a constant temperature within a bonding temperature range of 150-300°C, preferably of 150-250°C, under a vacuum of 13.3 Pa (0.1 Torr) or below and at a pressure of 9.8 to 196MPa (1.0-20 kgf/mm²), preferably, 29.4-98MPa (3-10kgf/mm²). In this way a sputtering target assembly is obtained. To avoid the formation of oxides, the bonding desirably is carried out in a vacuum atmosphere of 13.3 Pa (0.1 Torr) or below. The choice of load to be applied depends upon the bonding temperature and the materials to be used. For sufficient pressure bonding to produce interfacial diffusion, the load must be at least 9.8MPa (1.0kgf/mm²). On the other hand, a load in excess of 196MPa (20 kgf/mm²) can damage the target material. The bonding temperature is set within 150-300 ° C for the following reasons. If it is below 150 °C insufficient diffusion of atoms results in poor adhesion. If it exceeds 300 °C crystal grain growth takes place in the target material. Moreover, because of the difference in thermal expansion rate, the target material and backing plate tend to warp or distort, leading to inadequate bonding.

The sputtering target assembly thus obtained shows no deterioration of the target material, has bonded interfaces with a bonding area percentage of 100% produced by liquid phase-free solid phase diffusion bonding, and can satisfactorily be used even in a high-power sputtering system. In addition, the crystal grain size of the target material can be kept below a required standard, specifically no more than 250 µm for target materials having melting points of no more than 1000°C and preferably no more than 100 µm for an assembly of titanium target material and titanium backing plate, and uniform sputtering can be ensured. To reduce the adsorbed water, gas and the like on the target surface, it is possible to bake the target itself at about 200 °C before use unlike the case where a low-melting brazing filler metal is used.

Further explanations will be made with the Examples. The Examples set forth herein are merely for illustration and do not intend the restriction of this invention.

### (Example 1)

An Al- 1%Si-0.5% Cu target material in the form of a disk 300 mm in diameter and an oxygen-free copper (OFC) backing plate of the same size were ultrasonically degreased and rinsed with acetone. An insert of Ag foil 100 µm thick was used. The insert, after the ultrasonic degreasing and rinsing with acetone, was sandwiched between the Al-1%Si-0.5% Cu target material and the OFC backing plate.

The laminate consisting of the Al-1%Si-0.5%Cu target material, Ag foil insert, and OFC backing plate was diffusion-bonded in a vacuum of 6.7 mPa (5 x 10⁻⁵ Torr), at a bonding temperature of 250 °C and under a load of 78.4MPa (8 kgf/mm²). The grain size of the target after the bonding was 150 µm.

Solid-phase diffusion bonding was performed similarly but changing the bonding temperature alone to 350 °C. The grain size was now 400 µm.

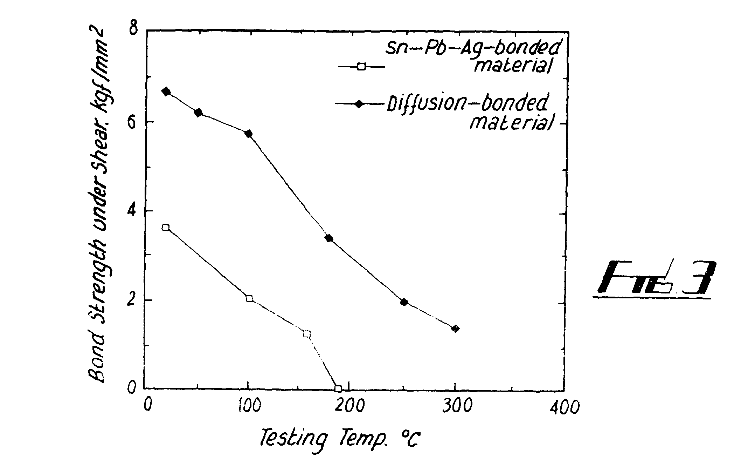

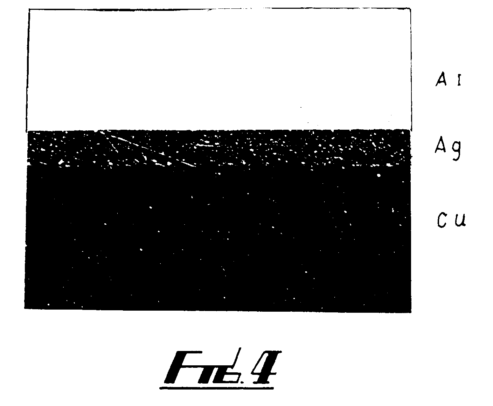

The bond strength values under shear at room temperature of test pieces cut out of five different diametral points of the diffusion-bonded material are compared, in FIG. 2, with those of corresponding test pieces of a laminate consisting of the same Al-1%Si-0.5% Cu target material and OFC backing plate similarly bonded but with an ordinary low-melting brazing material of the Sn-Pb-Ag system. FIG. 3 shows the temperature dependence of the bond strength values under shear of these bonded materials. As is obvious from FIGS. 2 and 3, the bond strength under shear of the laminate using the Sn-Pb-Ag low-melting brazing material is about 3 kg/mm², while the material solid-phase diffusion-bonded in accordance with this invention has about twice the strength, the values being around 58.8MPa (6 kgf/mm²). As for the temperature dependence, the bond strength under shear of the material using the Sn-Pb-Ag low-melting brazing material becomes zero in the vicinity of 180 °C which is the melting point of the brazing material itself. The solid-phase diffusion-bonded material of this invention, by contrast, exhibits a bond strength under shear of 29.4MPa (3kgf/mm²) or more above 200 °C and retains a strength of 19.6MPa (2kgf/mm²) even above 250 °C. FIG. 4 is a micrograph of a cross section illustrating the bond interfaces and neighboring portions of a laminate composed of an Al-1%Si-0.5% Cu target, Ag foil, and OFC backing plate according to the present invention.

### [Advantages of the invention]

Solid-phase diffusion bonding at a low temperature and pressure has the following features:
(1) The uniformity of crystal structure is maintained with the suppression of crystal grain growth.
(2) The process of fabrication causes no damage to the target material.
(3) Interdiffusion of the atoms constituting the target material, backing plate, and insert if used across the bond interfaces produces high degrees of adhesion and bond strength.
(4) The sharp drop of bond strength is avoided as found in the rise of the service temperature that can occur with a low-melting brazing material.
(5) Solid-phase bonding gives reliable bonds of a bonding area percentage of 100% without non-bonded portions such as pores that can result from ordinary bonding, due to shrinkage on solidification of a brazing material.

Consequently, this invention offers advantages as follows:
(a) A target material can be bonded to a backing plate without the possible danger of being damaged ; (b) uniformity of sputtering is ensured with the result that the film thickness is kept constant and the film properties are made uniform and stable; (c) a greater electric power can be put for sputtering, and therefore the throughput for film forming by sputtering can be improved; and (d) the target itself can be baked at around 200 °C, thus reducing adsorbed water, gas, and the like in the target surface.

## Claims

1. A method of manufacturing a sputtering target assembly having a target and a backing plate bonded thereto, comprising laminating the target of a given final shape, said target having a melting point below 1000°C, and the backing plate of a given final shape with at least one insert interposed therebetween, and solid-phase diffusion bonding the target to the backing plate, wherein said solid-phase diffusion bonding takes place under a vacuum at a temperature between 150 and 300°C and at a pressure of between 9.8MPa (1kgf/mm²) and 196MPa (20kgf/mm²) whereby the structure and crystal characteristics possessed by the target before being diffusion bonded to the backing plate are maintained after diffusion bonding and said target having a uniform crystal structure with a grain size not exceeding 250 µm.

## Patentansprüche

1. Verfahren zur Herstellung einer Kathodenzerstäubungstarget-Anordnung mit einem Target und einer damit verbundenen Rückplatte, bei dem das eine gegebene endgültige Form aufweisende Target, das einen Schmelzpunkt unter 1000°C hat, und die eine gegebene endgültige Form aufweisende Rückplatte mit mindestens einem dazwischen angeordneten Einsatz laminiert werden und das Target mit der Rückplatte durch Festkörperphasen-Diffusion verbunden wird, wobei die Verbindung mittels Festkörperphasen-Diffusion in einem Vakuum bei einer Temperatur von 150 °C bis 300 °C und einem Druck von 9,8 MPa (1 kgf/mm²) bis 196 MPa (20 kgf/mm²) stattfindet und wobei die Struktur und die Kristallkenngrößen, die das Target besitzt, bevor es mit der Rückplatte mittels Festkörperphasen-Diffusion verbunden wird, nach der Diffusionsverbindung beibehalten werden und das Target eine gleichförmige Kristallstruktur mit einer Korngröße von nicht mehr als 250 µm hat.

## Revendications

1. Procédé de fabrication d'un ensemble formant cible de pulvérisation ayant une cible et une plaque de support fixée sur celle-ci, comportant l'étape consistant à stratifier la cible d'une forme finale donnée, ladite cible ayant un point de fusion situé en dessous de 1 000°C, et la plaque de support d'une forme finale donnée, au moins un élément rapporté étant interposé entre celles-ci, et à fixer par diffusion en phase solide la cible sur la plaque de support, ladite fixation par diffusion en phase solide étant réalisée sous vide à une température comprise entre 150 et 300°C et à une pression comprise entre 9,8 MPa et 196 MPa (1 kgf/mm² et 20 kgf/mm²) de sorte que les caractéristiques cristallines et de structure possédées par la cible avant d'être fixée par diffusion sur la plaque de support sont maintenues après fixation par diffusion et ladite cible a une structure cristalline uniforme ayant une taille de grain ne dépassant pas 250 µm.
